# EUROPEAN PATENT APPLICATION

(11) **EP 2 320 270 A1**
(43) Date of publication of application: **11.05.2011**
(21) Application number: 09804799.6
(22) Date of filing: 27.05.2009
(51) Int. Cl.: G02F 1/1345, G01R 31/00, G02F 1/133, G09G 3/20, G09G 3/36, G02F 1/13

(54) **LIQUID CRYSTAL DISPLAY DEVICE TESTING METHOD AND LIQUID CRYSTAL DISPLAY DEVICE**

(30) Priority: 06.08.2008 JP 2008203543
(71) Applicant: Sharp Kabushiki Kaisha, Osaka-shi, Osaka 545-8522 (JP)
(72) Inventor: MIZUMAKI, Hidetaka, Osaka 545-8522 (JP)
(74) Representative: Müller-Boré & Partner Patentanwälte
(86) International application number: PCT/JP2009/059714
(87) International publication number: WO 2010/016312

(57) **Abstract**

An FPC (2) includes: wiring lines (8a) and (8b) which extend toward a display panel (1); and terminals (T1 and (T2) which are connected to the wiring lines (8a) and (8b), respectively. The display panel (1) includes a short-circuit wiring line (5) for short-circuiting the wiring lines (8a) and (8b). The EPC (2) and the display panel (1) are connected to each other so that the wiring lines (8a) and (8b) are short-circuited via the short-circuit wiring line (5) in a connection part between the FPC (2) and the display panel (1). A liquid crystal display device (30) includes a signal application circuit (31) for applying a signal to the terminal (T1) and a monitoring circuit (32) for comparing the signal applied to the terminal (T1) with a signal outputted from the terminal (T2). This provides a method of testing a liquid crystal display device and a liquid crystal display device each of which can check a connection condition between a display panel and a wiring board, such as a flexible circuit board (such as a COF and an FPC), not only while the liquid crystal display device is manufactured but also while the liquid crystal display device is in use.

## Description

### Technical Field

The present invention relates to: a method for testing a liquid crystal display device including a display panel and a wiring board which (i) is connected to the display panel and (ii) includes a wiring line via which a signal for driving the display panel is supplied; and a liquid crystal display panel employing the method.

### Background Art

A flat panel display device, such as a liquid crystal display device, has been used widely and popularly because of an advantage of its thin body which can be easily obtained. The flat panel display device includes a display panel which includes a great number of pixels. Signal for driving the plurality of pixels are supplied to the display panel from a driving circuit. The driving circuit is an integrated circuit in a form of COF (Chip On Film), for example, and is externally attached to the display panel. Alternatively, the driving circuit is directly provided on a glass substrate of the display panel in a form of COG (Chip On Glass). In this case, (i) the display panel is connected to an FPC (Flexible Printed Circuit) on which a wiring line is provided, and (ii) the driving signal is supplied, via the wiring line, to the driving circuit provided on the glass substrate.

The COF or the FPC should be stably connected to the display panel so as to ensure a reliable signal communication with the display panel. In order to cause such a connection condition to be more stable, a technique for structurally reinforcing the FPC has been disclosed, for example (Patent Literature 1). According to the technique, reinforcement members which are not involved in an electrical connection are provided in respective outer end parts of the FPC, which are likely to be subjected to stresses.

Further, whether or not the connection is surely maintained is inspected while the display device is manufactured, which inspection is carried out after the COF or the FPC is connected to the display panel. Generally, indentations which are formed in a connection part by thermocompression bonding are visually inspected by an automated machine employing a microscope. Specifically, images of the indentation part are captured, and the condition of the indentations, such as its depth or its size, is analyzed on the basis of the images thus captured.

### Citation List

### Patent Literature 1

Japanese Patent Application Publication, Tokukaihei, No. 05-183247 A (Publication Date: July 23, 1993)

### Summary of Invention

### Technical Problem

The flat panel display device has been widely used as a display section for various devices because it can have a thin body. Application of the flat panel display device to an in-car display device or a display device of a control device has been developed, for example. In such a field, an apparatus employing the flat panel display device is often used in a harsh environment. The flat panel display device provided in a vehicle is used under harsh conditions, such as vibrations, high temperatures, and low temperatures, for example. The flat panel display device provided in an apparatus used in a factory or the like is also likely to be used under similar harsh conditions.

The flat panel display device used in such a harsh environment has a higher risk of a breakdown of a film substrate used in the COF or the FPC (particularly, in the connection part between the COF or the FPC and the display panel), as compared with a flat panel display device used in a normal environment. This is because in a case where the flat panel display device is used in such a harsh environment, the film substrate is likely to be subjected to stresses.

According to the foregoing technique, the FPC is reinforced structurally so as to reduce the risk of a breakdown of the FPC due to stresses. However, there is also a case where the FPC thus reinforced is damaged due to long-term stresses as a result of long-term use of the flat panel display device in such a harsh environment. In a case where the FPC has a breakdown in the display device in use due to such long-term stresses, the display panel might become incapable of displaying an image because of a disconnected wiring line. In this case, a user has a problem in driving the vehicle or in operating the control device.

Further, the connection condition can be checked by the inspection of the indentations only while the display device is manufactured but not after the display device is shipped as a product. Therefore, in a case where (i) the display device has been used in such a harsh environment for a long time, and (ii) the COF or the FPC becomes ultimately almost broken down due to the long-term stresses, the user cannot recognize such a connection condition. If the display device in which the COF or the FPC is almost broken down is kept being used, the COF or the FPC will ultimately broken down, and the display panel will become incapable of displaying an image.

The present invention is made in view of the problems. An object of the present invention is to provide a method for testing a liquid crystal display device and a liquid crystal display device each of which allows an inspection of a connection condition between a display panel and a wiring board such as a flexible circuit board (a COF, an FPC, etc.) not only while the liquid crystal display device is manufactured but also while the liquid crystal display device is in use.

### Solution to Problem

In order to attain the object, a method of the present invention, for testing a liquid crystal display device, the liquid crystal display device including: a wiring board including (i) a signal supply line via which a signal for driving a display panel is supplied (ii) a first wiring line and a second wiring line which extend toward the display panel and (iii) a first terminal and a second terminal which are connected to the first wiring line and the second wiring line, respectively; and a display panel including a first short-circuit wiring line via which the first wiring line and the second wiring line are to be short-circuited in a connection part between the wiring board and the display panel, includes the steps of: (a) causing the wiring board and the display panel to be connected to each other; (b) applying a signal to the first terminal; and (c) comparing the signal applied to the first terminal with a signal outputted from the second terminal.

Further, in order to attain the object, a liquid crystal display device of the present invention includes: a wiring board including (i) a signal supply line via which a signal for driving a display panel is supplied (ii) a first wiring line and a second wiring line which extend toward the display panel and (iii) a first terminal and a second terminal which are connected to the first wiring line and the second wiring line, respectively; and a display panel including a first short-circuit wiring line via which the first wiring line and the second wiring line are to be short-circuited in a connection part between the wiring board and the display panel, the wiring board and the display panel being connected to each other, the liquid crystal display device further including: signal application means for applying a signal to the first terminal; and comparison means for comparing the signal applied to the first terminal with a signal outputted from the second terminal.

According to the arrangement, (i) in a case where the first wiring line is almost broken down or has been broken down, a resistance of the first wiring line is increased, and (ii) in a case where the second wiring line is almost broken down or has been broken down, a resistance of the second wiring line is increased. It follows that an end part of the first wiring line or the second wiring line which has the increased resistance is largely reduced in voltage with respect to a current flowing through the first wiring line or the second wiring line having the increased resistance. For this reason, the signal outputted from the second terminal, which is monitored by the comparison means, becomes different from the signal applied to the first terminal. It becomes thus possible to detect a defect of either the first wiring line or the second wiring line.

Further, it is possible to arrange such that information indicating a poor connection condition between the display panel and the wiring board is fed back to control means in a case where it is determined, as a result of monitoring of the comparison means, that the connection condition between the display panel and the wiring board has become poor. The control means is a signal source connected to the liquid crystal display device. The control means to carry out a preventive control with respect to the liquid crystal display device, such as turning off a back light of the liquid crystal display device or stopping a voltage supply to the liquid crystal display device, in response to the information on the connection condition between the display panel and the wiring board of the liquid crystal display device.

The signal application means, the comparison means, and the control means can operate either while the liquid crystal display device is manufactured or while the liquid crystal display device is in use. This allows a user to check the connection condition between the display panel and the wiring board not only while the liquid crystal display device is manufactured but also while the liquid crystal display device is in use after being manufactured.

In the method for testing a liquid crystal display device, described above, in the step (a), the wiring board and the display panel may be connected to each other via an intermediate substrate, which includes (i) a wiring line via which a signal is communicated between the display panel and the wiring board and (ii) a third wiring line and a fourth wiring line, so that (1) the first wiring line and the first short-circuit wiring line are electrically connected via the third wiring line and (2) the second wiring line and the first short-circuit wiring line are electrically connected via the fourth wiring line.

Further, in the liquid crystal display device described above, the wiring board and the display panel may be connected to each other via an intermediate substrate, which includes (i) a wiring line via which a signal is communicated between the display panel and the wiring board and (ii) a third wiring line and a fourth wiring line, so that (1) the first wiring line and the first short-circuit wiring line are electrically connected via the third wiring line and (2) the second wiring line and the first short-circuit wiring line are electrically connected via the fourth wiring line.

According to the method and the arrangement of the liquid crystal display device, it becomes possible to detect a defect not only in the first and second wiring lines but also in the third and fourth wiring lines.

In the method for testing a liquid crystal display device, described above, (1) the wiring board may further include (i) a fifth wiring line and a sixth wiring line and (ii) a third terminal and a fourth terminal which are connected to the fifth wiring line and the sixth wiring line, respectively, (2) the intermediate substrate may further include a second short-circuit wiring line via which the fifth wiring line and the sixth wiring line are to be short-circuited in a connection part between the wiring board and the intermediate substrate, (3) and the method may further include the steps of: causing the wiring board and the intermediate substrate to be connected to each other; applying a signal to the third terminal; and comparing the signal applied to the third terminal with a signal outputted from the fourth terminal.

Further, in the liquid crystal display device described above, (i) the wiring board may further include (i) a fifth wiring line and a sixth wiring line and (ii) a third terminal and a fourth terminal which are connected to the fifth wiring line and the sixth wiring line, respectively, (2) the intermediate substrate may further include a second short-circuit wiring line via which the fifth wiring line and the sixth wiring line are to be short-circuited in a connection part between the wiring board and the intermediate substrate, (3) the signal application means may apply a signal to the third terminal, and (4) the comparison means may compare the signal applied to the third terminal with a signal outputted from the fourth terminal.

According to the method and the arrangement of the liquid crystal display device, it becomes possible to also detect a defect either in the fifth wiring line or in the sixth wiring line.

In the method for testing a liquid crystal display device, described above, the signal applied to the first terminal may be a pulse signal.

According to the method, (i) in a case where the first wiring line is almost broken down or has been broken down, the resistance of the first wiring line is increased, and (ii) in a case where the second wiring line is almost broken down or has been broken down, the resistance of the second wiring line is increased. It follows that the signal outputted from the second terminal has a waveform which is less sharp than that of the signal applied to the first terminal. It becomes thus possible to detect a defect either in the first wiring line or in the second wiring line.

In the method for testing a liquid crystal display device, described above, the signal applied to the first terminal may be a DC signal.

According to the method, (i) in a case where the first wiring line is almost broken down or has been broken down, the resistance of the first wiring line is increased, and (ii) in a case where the second wiring line is almost broken down or has been broken down, the resistance of the second wiring line is increased. It follows that the signal outputted from the second terminal has a DC level which is less than that of the signal applied to the first terminal. It becomes thus possible to detect a defect either in the first wiring line or in the second wiring line.

In the liquid crystal display device, described above, the first wiring line and the second wiring line may be provided in at least one of lateral end parts of the wiring board.

This makes it possible to easily estimate (i) a broken condition of, in particular, the lateral end parts of the wiring board, which lateral end parts are likely to be subjected to stresses and (ii) the connection condition between the wiring board and the display panel.

In the liquid crystal display device, described above, the intermediate substrate may be made up of a plurality of intermediate substrates, and the wiring board and the display panel may be connected to each other via the plurality of intermediate substrates.

This makes it possible to assume, for each of the plurality of intermediate substrates, either (i) the connection condition between the wiring board and that intermediate substrate or (ii) the connection condition between the display panel and that intermediate substrate.

In the liquid crystal display device, described above, each of the plurality of intermediate substrates may include the fifth wiring line and the sixth wiring line in each of its lateral end parts.

In the liquid crystal display device, described above, the wiring board may be a printed wiring board, and the intermediate substrate may be a wiring board in which an integrated circuit for driving the display panel is provided on a film.

This makes it possible to estimate the connection condition between the wiring board which is easily damaged due to stresses such as long-term vibrations, and the printed circuit board.

### Advantageous Effects of Invention

As described above, a method of the present invention, for testing a liquid crystal display device, the liquid crystal display device including: a wiring board including (i) a signal supply line via which a signal for driving a display panel is supplied (ii) a first wiring line and a second wiring line which extend toward the display panel and (iii) a first terminal and a second terminal which are connected to the first wiring line and the second wiring line, respectively; and a display panel including a first short-circuit wiring line via which the first wiring line and the second wiring line are to be short-circuited in a connection part between the wiring board and the display panel, includes the steps of: (a) causing the wiring board and the display panel to be connected to each other; (b) applying a signal to the first terminal; and (c) comparing the signal applied to the first terminal with a signal outputted from the second terminal.

Further, as described above, a liquid crystal display device of the present invention includes: a wiring board including (i) a signal supply line via which a signal for driving a display panel is supplied (ii) a first wiring line and a second wiring line which extend toward the display panel and (iii) a first terminal and a second terminal which are connected to the first wiring line and the second wiring line, respectively; and a display panel including a first short-circuit wiring line via which the first wiring line and the second wiring line are to be short-circuited in a connection part between the wiring board and the display panel, the wiring board and the display panel being connected to each other, the liquid crystal display device further including: signal application means for applying a signal to the first terminal; and comparison means for comparing the signal applied to the first terminal with a signal outputted from the second terminal.

Therefore, it becomes possible to check a connection condition between the display panel and the wiring board such as a flexible circuit board (a COF, an FPC, etc.) not only while the liquid crystal display device is manufactured but also while the liquid crystal display device is in use after being manufactured.

Additional objects, features, and strengths of the present invention will be made clear by the description below. Further, the advantages of the present invention will be evident from the following explanation in reference to the drawings.

### Brief Description of Drawings

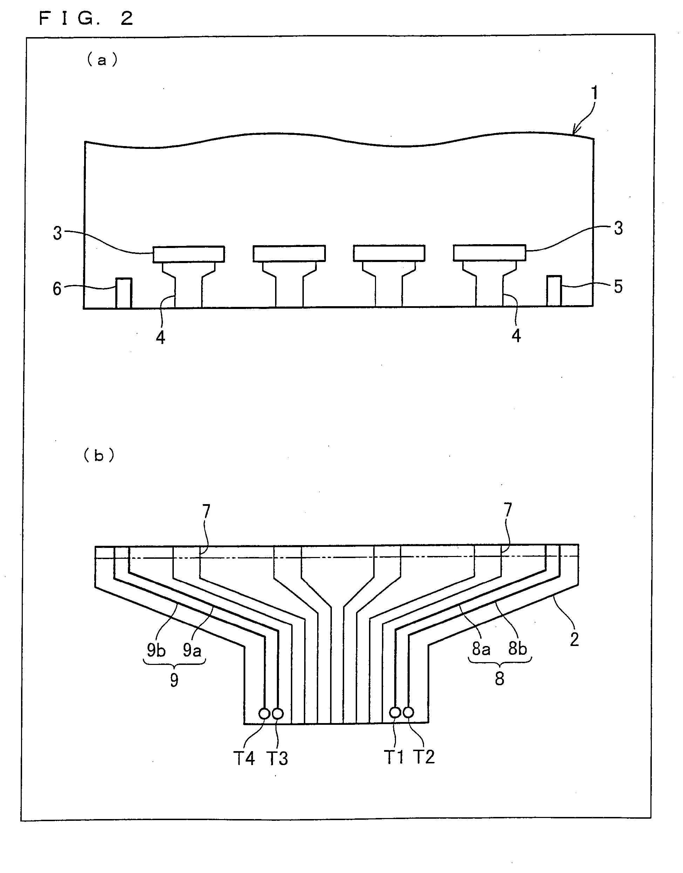

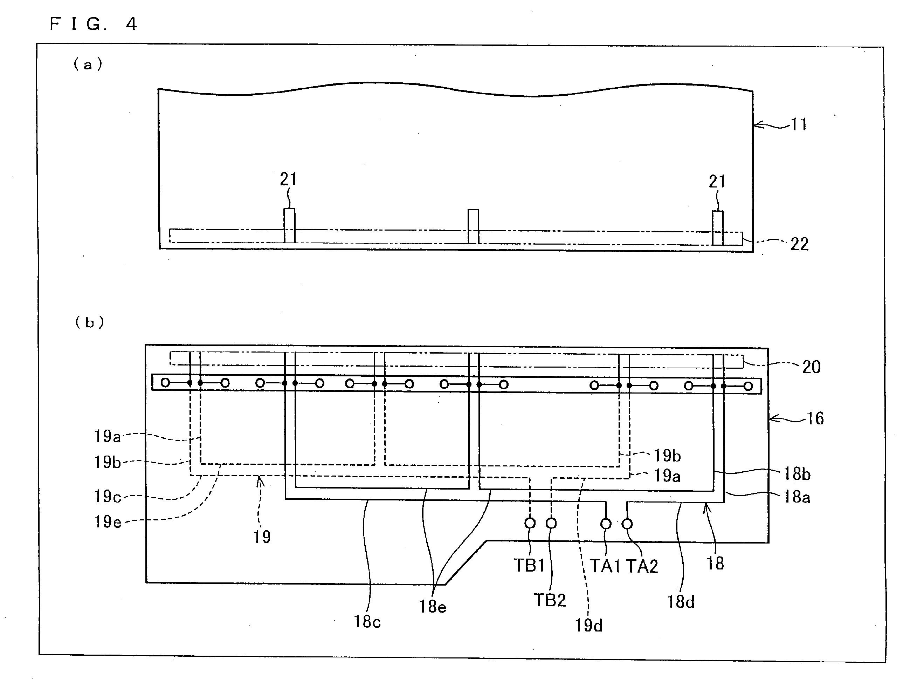

Fig. 1

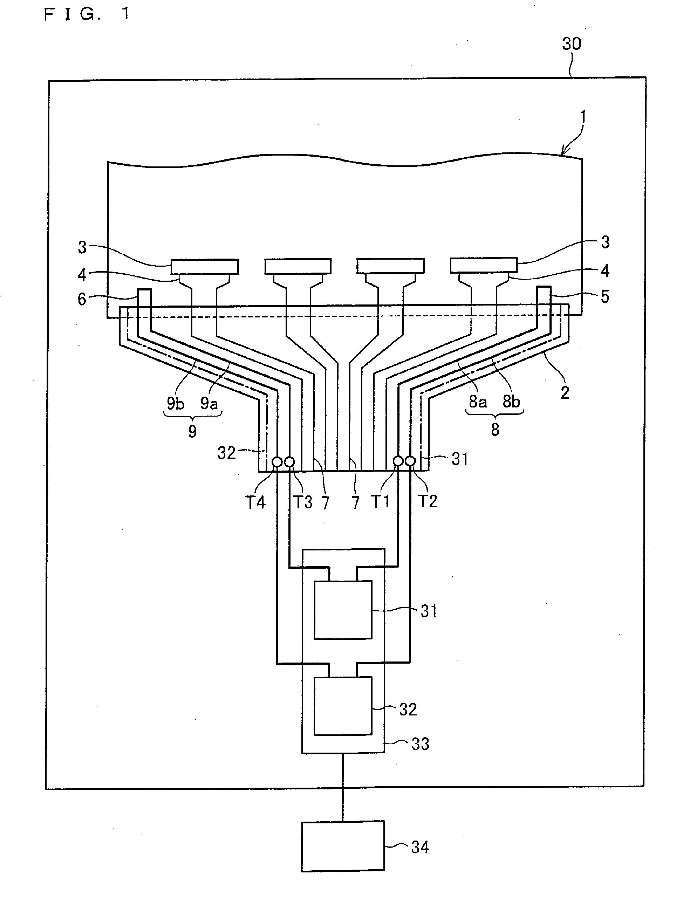

   Fig. 1 is a plan view illustrating how a display panel and an FPC are connected to each other in a liquid crystal display device in accordance with Embodiment 1 of the present invention.
Fig. 2
   (a) of Fig. 2 is a plan view illustrating an arrangement of the display panel illustrated in Fig. 1, and (b) of Fig. 2 is a plan view illustrating an arrangement of the FPC illustrated in Fig. 1.
Fig. 3

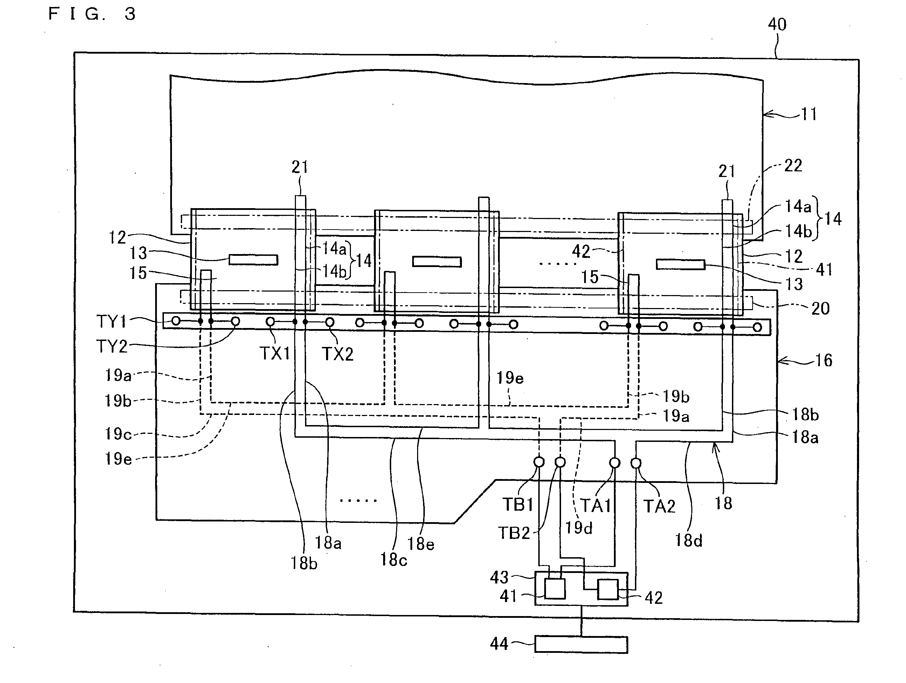

   Fig. 3 is a plan view illustrating how a display panel and a PWB are connected to each other in a liquid crystal display device in accordance with Embodiment 2 of the present invention.
Fig. 4
   (a) of Fig. 4 is a plan view illustrating an arrangement of the display panel illustrated in Fig. 3, and (b) of Fig. 4 is a plan view illustrating an arrangement of the PWB illustrated in Fig. 3.
Fig. 5

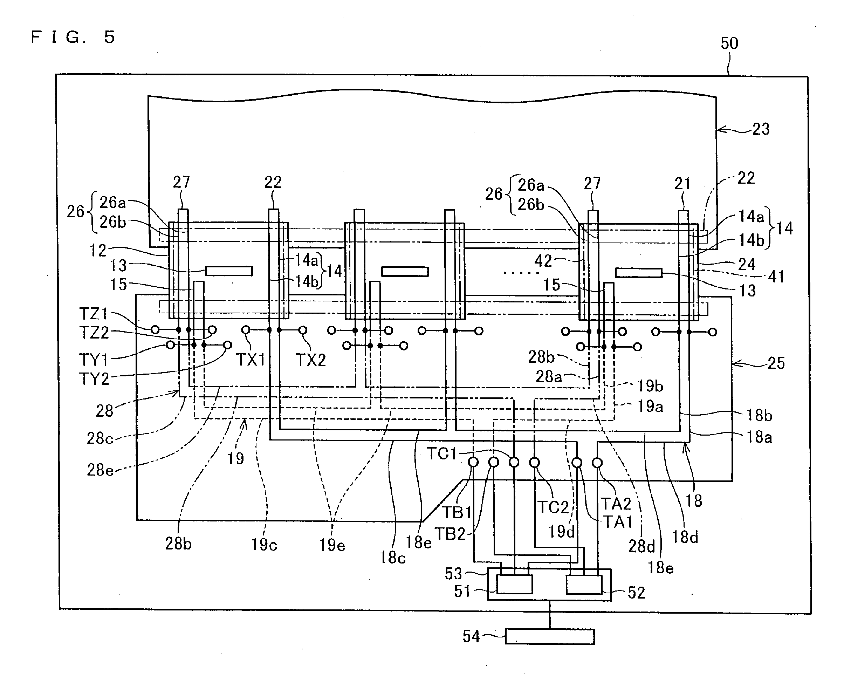

   Fig. 5 is a plan view illustrating an arrangement of a modified example of Embodiment 2.
Fig. 6

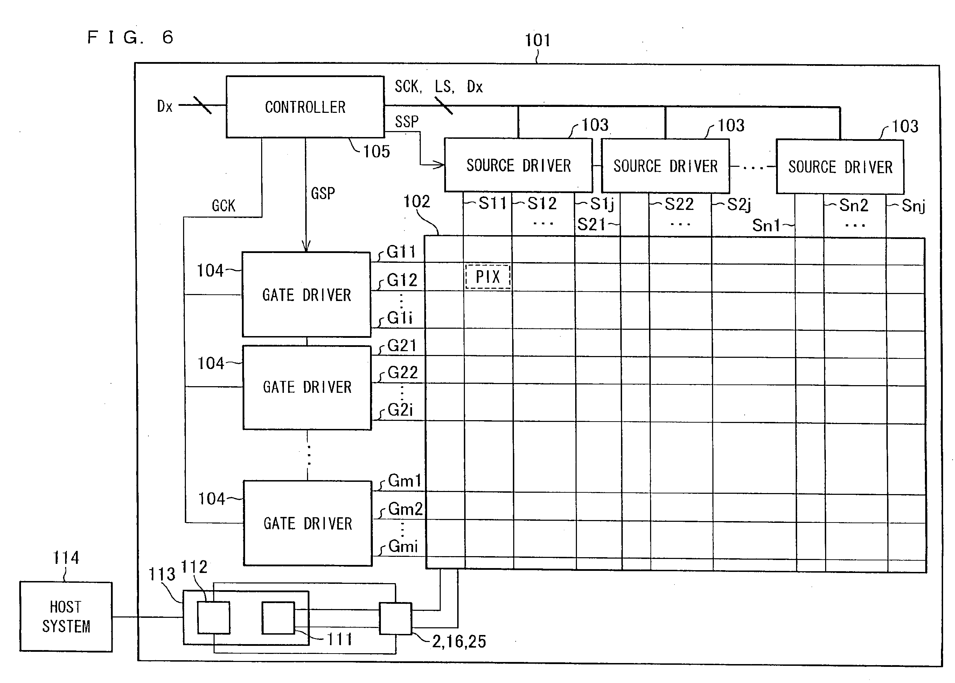

   Fig. 6 is a block diagram illustrating an arrangement of a liquid crystal display device in accordance with Embodiment 3.

### Description of Embodiments

Embodiments of the present invention are described below with reference to Figs. 1 through 6.

### [Embodiment 1]

Fig. 1 illustrates how a display panel 1 and an FPC 2 are connected to each other in a liquid crystal display device 30 of the present embodiment. Further, (a) of Fig. 2 illustrates the display panel 1 which is not connected to the FPC 2, and (b) of Fig. 2 illustrates the FPC 2 which is not connected to the display panel 1.

A plurality of driver chips 3 are arranged on one of end parts of the display panel 1 in a form of COG (see Fig. 1). The plurality of driver chips 3 are integrated driving circuits for driving a plurality of pixels of the display panel 1. The plurality of pixels receive their driving signals via the plurality of driver chips 3. The driving signal includes display data, a selection signal for selecting a scan line, and the like.

Further, wiring patterns 4 are provided on a surface of the display panel 1, where the respective plurality of driver chips 3 are to be provided. This allows each of the plurality of driver chips 3 to receive, via a corresponding one of the wiring patterns 4, various signals, which are prepared in accordance with a driving method, such as a clock signal for controlling output timing of the display data and a clock signal for controlling timing of the selection signal. Each of the wiring patterns 4 has a plurality of wiring lines (not illustrated) via which a plurality of signals are supplied to a corresponding one of the plurality of driver chips 3 from the FPC 2.

Short-circuit wiring lines 5 and 6 are further provided, on the surface of the display panel 1, in respective lateral end parts of the end part where the plurality of driver chips 3 are provided. Details of the short-circuit wiring lines 5 and 6 will be described later.

The FPC 2 is constituted by providing wiring patterns 7 on a film substrate made from a material such as polyimide. The wiring patterns 7 are provided for the respective plurality of driver chips 3 so as to supply the aforementioned signals to the plurality of driver chips 3. Like the wiring patterns 4, each of the wiring patterns 7 has a plurality of wiring lines (not illustrated).

The FPC 2 and the display panel 1 are connected to each other via an ACF (Anisotropic Conductive Film) so that their respective connection end parts overlap each other. This causes the wiring patterns 4 and 7 to be electrically connected to each other.

Test wiring sections 8 and 9 are provided on the FPC 2 (see (b) of Fig. 2). The test wiring sections 8 and 9 are provided in the vicinity of the respective lateral end parts of the FPC 2 so as to sandwich all of the wiring patterns 7 between them. The test wiring section 8 is constituted by wiring lines 8a and 8b which are juxtaposed to each other, while the test wiring section 9 is constituted by wiring lines 9a and 9b which are juxtaposed to each other. The wiring lines 8a, 8b, 9a, and 9b extend respectively from terminals T1through T4 provided on an input end part of the FPC 2 to a connection part of the FPC 2, to which the display panel 1 is connected.

Further, the terminals T1 and T3 are connected to a signal application circuit 31, while the terminals T2 and T4 are connected to a monitoring circuit 32. The signal application circuit 31 and the monitoring circuit 32 are included in a test circuit 33 which is connected to a host system 34 (later described).

Each of the short-circuit wiring lines 5 and 6 has a square-cornered U-shape and its both end parts reach a connection end part of the display panel 1 (see (a) of Fig. 2). The wiring lines 8a and 8b are electrically connected to each other via the short-circuit wiring line 5, while the wiring lines 9a and 9b are electrically connected to each other via the short-circuit wiring line 6 (see Fig. 1). Thus, the wiring lines 8a and 8b and the short-circuit wiring line 5 are electrically connected to each other as a single wiring line, while the wiring lines 9a and 9b and the short-circuit wiring line 6 are electrically connected to each other as another single wiring line.

In such connection conditions, (i) input signals each having an arbitrary test waveform are supplied from the signal application circuit 31 to the respective terminals T1and T3, and (ii) signals outputted from the respective terminals T2 and T4 are monitored by the monitoring circuit 32. This makes it possible to estimate a broken condition of the FPC 2 or a connection condition between the display panel 1 and the FPC 2.

For example, in a case where (i) the input signals supplied to the terminals T1 and T3 and the respective output signals outputted from the terminals T2 and T4, monitored by the monitoring circuit 32, are compared with each other and (ii) the input signals and the output signals have substantially identical waveforms as a result of the comparison, it can be determined that the input signals are transmitted in the respective test wiring sections 8 and 9 without any failure. In this case, it is believed that the connection between the display panel 1 and the FPC 2 is normal, and therefore at least parts of the FPC 2, where the test wiring sections 8 and 9 are provided, have no breakdown.

In a case where there is at least one of the terminals T2 and T4 from which no output signal is outputted, it is highly likely (i) for the test wiring section 8 and/or 9 from which no output signal is outputted to be broken or (ii) for (a) the connection condition between the test wiring sections 8 and the short-circuit wiring line 5 and/or (b) the connection condition between the test wiring sections 9 and the short-circuit wiring line 6 to become poor. In such a case, it is highly likely that (i) an edge (lateral end) part of the FPC 2 is broken down or (ii) the connection condition between the display panel 1 and the FPC 2 becomes poor.

Furthermore, in a case where (i) the waveform of an output signal which is outputted from the terminal T2 or T4 and is monitored by the monitoring circuit 32 or (ii) the waveforms of output signals which are outputted from the respective terminals T2 and T4 and are monitored by the monitoring circuit 32 is(are) less sharp than those of the input signals supplied to the respective terminals T1 and T3, it is likely for the test wiring section 8 and/or 9 to have increased resistance(s) due to the reason such as a breakdown.

The signal supplied to each of the terminals T1and T3 from the signal application circuit 31 can be, but not limited to, a pulse signal, for example. For a simplified test, the signal supplied to each of the terminals T1 and T3 can be a DC level signal (DC signal).

In this case, increases in resistances of the respective test wiring sections 8 and 9 cause voltage drops in proportion to currents flowing through the respective test wiring sections 8 and 9. It follows that DC levels of the respective terminals T2 and T4 are reduced more than those of the respective terminals T1 and T3. It is thus possible to detect whether or not the test wiring sections 8 and 9 have their respective defects by detecting the reductions in DC levels of the respective terminals T2 and T4.

Note that, in a case where the test wiring sections 8 and 9 have their respective normal resistances, the reductions in DC levels of the respective terminals T2 and T4 are so small that these are ignorable.

As described above, the test wiring sections 8 and 9 have respective higher resistances in the following malfunctional cases than in normal case: (i) the test wiring sections 8 and 9 are almost in respective disconnected conditions and (ii) the test wiring sections 8 and 9 are in respective disconnected conditions. It follows that the output signals outputted from the respective terminals T2 and T3, monitored by the monitoring circuit 32, become different from the input signals supplied to the respective terminals T1 and T3 from the signal application circuit 31. That is, voltage drops, across the respective parts whose resistances are increased, increase while currents are flowing through the respective parts. It becomes thus possible to detect defects of the respective test wiring sections 8 and 9.

It is possible to arrange a system so that information indicating that there is a defect in the connection condition between the display panel 1 and the FPC 2 is fed back to the host system 34 via the test circuit 33 included in the liquid crystal display device 30, in a case where it is determined, by use of the monitoring method described above, that there is a defect in the connection condition between the display panel 1 and the FPC 2. The host system 34 is a signal source connected to the liquid crystal display device 30. The host system 34 can carry out a preventative control, such as turning off a backlight of the liquid crystal display device 30 or stopping a voltage supply to the liquid crystal display device 30, in response to the information on the connection condition between the display panel 1 and the FPC 2 of the liquid crystal display device 30.

Further, the connection condition between the display panel 1 and the FPC 2 can be monitored by (i) causing a signal source, which is provided on a substrate on which a driving circuit is provided and to which the display panel 1 is connected, to supply input signals to the respective terminals T1 and T3 and (ii) monitoring output signals outputted from the respective terminals T2 and T4. Alternatively, it is possible to arrange wiring lines so that the host system 34, serving as the signal source for the liquid crystal display device 30, controls all of the terminals T1 through T4.

In a case where the control can be carried out in the liquid crystal display device 30 without the host system 34, the liquid crystal display device 30 itself can carry out the control, such as turning on or off the backlight of the liquid crystal display device 30, in response to the information on the connection condition between the display panel 1 and the FPC 2.

Instead, it is possible to (i) compare (a) a measured resistance of the wiring line defined by the test wiring section 8 and the short-circuit wiring line 5 and (b) a normal resistance of the wiring line which has been measured in advance with each other and (ii) compare (c) a measured resistance of the wiring line defined by the test wiring section 9 and the short-circuit wiring line 6 and (d) a normal resistance of the wiring line which has been measured in advance with each other. Such comparisons make it possible to estimate (i) the broken condition of the FPC 2 or (ii) the connection condition between the display panel 1 and the FPC 2. In a case where each resistance of the wiring lines is much higher than a corresponding normal resistance, i.e., the resistance measured in the normal connection condition, it is believed that such a wiring line is almost in a disconnected condition. The terminals T1 through T4 can be used in the measurement of each resistance of the wiring lines.

According to the present embodiment, (i) the short-circuit wiring lines 5 and 6 are provided on the display panel 1 (ii) the test wiring sections 8 and 9 are provided on the FPC 2, and (iii) the short-circuit wiring lines 5 and 6 and the test wiring sections 8 and 9 are connected to each other, respectively. Further, the terminals T1and T2 are electrically connected to the test wiring section 8, while the terminals T3 and T4 are electrically connected to the test wiring section 9. The conditions of the output signals outputted from the respective terminals T2 and T4 with respect to the respective conditions of the input signals supplied to the respective terminals T1 and T3 are thus confirmed. As such, it is possible to easily estimate (i) the disconnected condition of the lateral end parts of the FPC 2, which are highly likely to be subjected to the stresses or (ii) the connection condition between the display panel 1 and the FPC 2, while the display device including the display panel 1 is in use. Alternatively, it is possible to estimate the disconnected condition or the connection condition by comparing (i) the measured resistance between the terminals T1 and T2 with the normal resistance measured in advance and (ii) the measured resistance between the terminals T3 and T4 with the normal resistance measured in advance.

Note that the present embodiment has dealt with the arrangement in which the test wiring section 8 is provided in the vicinity of one of lateral edges of the FPC 2, while the test wiring section 9 is provided in the vicinity of the other one of lateral edges of the FPC 2. Note, however, that one of the test wiring sections 8 and 9 can be omitted in a case where there is a restriction in layout of pins of the FPC2.

Note also that dummy wiring lines 31 and 32 can be further provided on the FPC 2 of the present embodiment (see dashed-dotted lines shown in Fig. 1). Specifically, the dummy wiring line 31 is provided between the test wiring section 8 and one of the lateral edges of the FPC 2, while the dummy wiring line 32 is provided between the test wiring section 9 and the other of the lateral edges of the FPC 2.

Generally, each of the dummy wiring lines 31 and 32 is provided as an independent wiring line which is in electrical contact with neither the display panel 1 nor an external device. Such dummy wiring lines 31 and 32 serve as members for reinforcing the FPC 2. The provision of such dummy wiring lines 31 and 32 allow the lateral edge parts of the FPC 2 to have higher strength.

Note that the dummy wiring lines 31 and 32 can be electrically connected to either the display panel 1 or the external device, if necessary.

### [Embodiment 2]

Fig. 3 illustrates how a display panel 11 and a PWB (Printed Wiring Board) 16 are connected to each other, via a plurality of COFs 12, in another liquid crystal display device 40 of the present embodiment. Further, (a) of Fig. 4 illustrates the display panel 11 which is not connected to the PWB 16, and (b) of Fig. 4 illustrates the PWB 16 which is not connected to the display panel 11.

The plurality of COFs 12 are arranged and connected to one of end parts of the display panel 11 (see Fig. 3). Further, a plurality of short-circuit wiring lines 21 are provided on connection parts, where the plurality of COFs 12 are to be provided, of the display panel 11. Details of the plurality of short-circuit wiring lines 21 will be described later.

Each of the plurality of COFs 12 is arranged such that a driver chip 13, an input wiring line (not illustrated), and an output wiring line (not illustrated) are provided on a film substrate made from a material such as polyimide. The input wiring line is provided via which a signal is supplied from the PWB 16 to the driver chip 13, and the output wiring line is provided via which a signal is supplied from the driver chip 13 to the display panel 11. The driver chip 13 has an arrangement similar to the foregoing driver chip 3. A plurality of pixels of the display panels 11 receive their driving signals via the plurality of driver chips 13 so as to be driven.

The COF 12 is in a form of SOF (System On Chip), TCP (Tape Carrier Package) or the like. The SOF is arranged so that a chip is mounted on a film substrate made from a material such as polyimide. In recent years, the SOF has become popular as an integrated driving circuit component of a liquid crystal driver or the like. The SOF thus arranged has an advantage that a wiring line can be formed even in a part where a chip is to be provided, unlike the TCP in which chips are provided in respective openings of a film substrate. Further, the SOF can be bent along an arbitrary line. This is because the SOF has no slit which regulates where to bend, unlike the TCP.

A test wiring section 14 and a short-circuit wiring line 15 are provided on each of the plurality of the COFs 12. The test wiring section 14 is defined by wiring lines 14a and 14b which are juxtaposed to each other. On the film substrate of the each of the plurality of the COFs 12, (i) the wiring lines 14a and 14b are provided on one side of the driver chip 13 so as to connect the display panel 11 and the PWB 16 and (ii) the short-circuit wiring line 15 is provided on the other side of the driver chip 13 so as to have a square-cornered U-shape. Both ends of the short-circuit wiring line 15 extend up to a connection part of the COF 12, to which connection part the PWB 16 is to be connected.

The display panel 11 and the plurality of COFs 12 are connected to each other in a connection part 22 via ACF such that a connection part of the display panel 11 and a connection part of each of the plurality of COFs 12 overlap each other. This causes the output wiring line of each of the plurality of COFs 12 and a corresponding input wiring line (not illustrated) of the display panel 11 to be electrically connected to each other.

As described above, the short-circuit wiring line 21 has the square cornered U-shape and both ends of the short circuit-wiring line 21 extends up to the connection part of the display panel 11 (see (a) of Fig. 4). Further, the wiring lines 14a and 14b are electrically connected to each other via the short-circuit wiring line 21. This causes the wiring lines 14a and 14b and the short-circuit wiring line 21 to serve as a single wiring line in combination with each other.

In the PWB 16, a controller (not illustrated) generates timing signals necessary to drive the display panel 11. Further, each wiring pattern (not illustrated) is provided on the PWB so as to face a corresponding one of the plurality of COFs 12. The wiring pattern includes a plurality of wiring lines (not illustrated) via which a corresponding one of the timing signals is transmitted to a driver chip 13 of the corresponding one of the plurality of COFs 12. The timing signals are prepared in accordance with a method for driving signals such as a clock signal for controlling output timing of display data or a clock signal for controlling timing of a selection signal, and are supplied from the controller (not illustrated) of the PWB 16. The timing signals are generated by the controller in response to a clock signal or externally supplied various pulse signals.

Note that the controller can be provided outside the PWB 16 instead of being provided in the PWB 16.

The PWB 16 includes test wiring sections 18 and 19, terminals TA1, TA2, TB1, and TB2, and intermediate terminals TX1, TX2, TY1, and TY2 (see (b) of Fig. 4). The test wiring section 18 is constituted by a plurality of wiring lines 18a, a plurality of wiring lines 18b, an input wiring line 18c, an output wiring line 18d, and a common wiring line 18e. The test wiring section 19 is constituted by a plurality of wiring lines 19a, a plurality of wiring lines 19b, an input wiring line 19c, an output wiring line 19d, and a common wiring line 19e.

The terminals TA1 and TB1 are connected to a signal application circuit 41, while the terminals TA2 and TB2 are connected to a monitoring circuit 42. The signal application circuit 41 and the monitoring circuit 42 are included in a test circuit 43 which is connected to a host system 44 (later described).

A pair of wiring lines 18a and 18b is provided for each of the plurality of COFs 12. The wiring lines 18a and 18b are connected to one ends of the respective wiring lines 14a and 14b. The input wiring line 18c is connected between the terminal TA1 and the wiring line 18b, the other end of the wiring line 18b being connected to the wiring line 14b of an outermost one of the plurality of COFs 12 (a leftmost COF 12 shown in Fig. 3). The output wiring line 18d is connected between the terminal TA2 and the wiring line 18a, the other end of the wiring line 18a being connected to the wiring line 14a of the other outermost one of the plurality of COFs 12 (a rightmost COF 12 in Fig. 3). The common wiring line 18e is connected between a wiring line 18a of one of neighboring pairs of wiring lines 18a and 18b and a wiring line 18b of the other of the neighboring pairs of wiring lines 18a and 18b.

In the same manner, a pair of wiring lines 19a and 19b is provided for each of the plurality of COFs 12. The pair of wiring lines 19a and 19b are connected to each other via the short-circuit wiring line 15. The input wiring line 19c is connected between the terminal TB1 and the wiring line 19b, the other end of the wiring line 19b being connected to the short-circuit wiring line 15 of an outermost one of the plurality of COFs 12 (the leftmost COF 12 shown in Fig. 3). The output wiring line 19d is connected between the terminal TB2 and the wiring line 19a, the other end of the wiring line 19a being connected to the short-circuit wiring line 15 of the other outermost one of the plurality of COFs 12 (the rightmost COF 12 shown in Fig. 3). The common wiring line 19e is connected between a wiring line 19a of one of neighboring pairs of wiring lines 19a and 19b and a wiring line 19b of the other of the neighboring pairs of wiring lines of 19a and 19b.

Further, each of the plurality of wiring lines 18a is connected to a corresponding one of the terminals TX2 on a side of a corresponding one of the plurality of COFs 12, and each of the plurality of wiring lines 18b is connected to a corresponding one of the terminals TX1 on a side of a corresponding one of the plurality of COFs 12. Meanwhile, each of the plurality of wiring lines 19a is connected to a corresponding one of the terminals TY2 on a corresponding one of the plurality of COFs 12, and each of the plurality of wiring lines 19b is connected to a corresponding one of the terminals TY1 on a side of a corresponding one of the plurality of COFs 12.

The PWB 16 and the plurality of COFs 12 are connected to each other via the ACF in a connection part 20 so that a connection part of the PWB 16 and a connection part of each of the plurality of COFs 12 overlap each other. This causes the input wiring line of each of the plurality of COFs and the wiring pattern 17 to be electrically connected to each other.

Further, each test wiring section 14 of the plurality of COFs 12 and a corresponding one of the test wiring sections 18 of the PWB 16 are electrically connected to each other. Specifically, the wiring lines 14a and 14b of each of the plurality of COFs 12 are electrically connected to respective corresponding wiring lines 18a and 18b. This causes the test wiring section 18, the test wiring section 14, and the plurality of short-circuit wiring lines 21 to serve as a single wiring line between the terminals TA1 and TA2.

Furthermore, each short-circuit wiring line 15 of the plurality of COFs 12 and the test wiring section 19 of the PWB 16 are electrically connected to each other. Specifically, corresponding wiring lines 19a and 19b of the PWB 16 are electrically connected to each other via a corresponding one of the short-circuit wiring lines 15 of the plurality of COFs 12. This causes the test wiring section 19 and the plurality of short-circuit wiring line 15 to serve as a single wiring line between the terminals TB1 and TB2.

In such connection conditions, (i) input signals each having an arbitral test waveform are supplied from the signal application circuit 41 to the respective terminals TA1 and TB1, and (ii) signals outputted from the respective terminals TA2 and TB2 are monitored by the monitoring circuit 42. This makes it possible to estimate (i) a broken condition of each of the plurality of COFs 12 and/or the PWB 16 or (ii) a connection condition between the display panel 11 and the plurality of COFs 12 and a connection condition between the plurality of COFs 12 and the PWB 16.

For example, in a case where (i) the input signals supplied to the terminals TA1 and TA3, and respective output signals outputted from the terminals TA2 and TA4, monitored by the monitoring circuit 42, are compared with each other, and (ii) the input signals and the output signals have substantially identical waveforms as a result of the comparison, it can be determined that the input signals are transmitted in the respective test wiring sections 14 and the respective test wiring sections 18 and 19 without any failure. In this case, it is believed that the connection between the display panel 11 and the plurality of COFs 12 and the connection condition between the plurality of COFs 12 and the PWB 16 are normal, the FPC 2 is normal, and therefore at least parts of the PWB 16, where the test wiring sections 18 and 19 are provided, has no breakdown.

In a case where only the terminal TA2 outputs no signal, it is highly likely (i) for the test wiring section 18 and/or at least one of the plurality of test wiring sections 14 to be broken or (ii) for (a) the connection condition between the test wiring section 18 and at least one of the plurality of test wiring sections 14 and/or the connection condition between at least one of the plurality of test wiring sections 14 and a corresponding one(s) of the plurality of short-circuit wiring lines 21 to become poor. In such a case, it is highly likely that (i) one of edge parts of at least one of the plurality of COFs 12 (a lateral end part of at least one of the plurality of COFs 12, where a corresponding one of the plurality of test wiring sections 14 is provided) is broken down or (ii) the connection condition between at least one of the plurality of COFs 12 and the PWB 16 and/or the connection condition between the display panel 11 and at least one of the plurality of COFs 12 become poor.

In a case where only the terminal TB2 outputs no signal, it is highly likely (i) for the test wiring section 19 to be broken down or (ii) for the connection condition between the test wiring section 19 and at least one of the plurality of short-circuit wiring lines 15 to become poor. In such a case, it is highly likely that (i) the other one of edge parts of at least one of the plurality of COFs 12 (a lateral end part of at least one of the plurality of COFs 12, where the short-circuit wiring line 19 is provided) is broken down or (ii) the connection condition between at least one of the plurality of COFs 12 and the PWB 16 becomes poor.

In a case where (i) only the terminal TA2 outputs the output signal, and (ii) the output signal, monitored by the monitoring circuit 42, has a waveform which is less sharp than that of the input signal supplied from the signal application circuit 41 to the terminal TA1, it is highly likely for at least one of the plurality of test wiring sections 14 or the test wiring section 18 to have an increased resistance due to the reason such as a breakdown. Further, in a case where (i) only the terminal TB2 outputs the output signal, and (ii) the output signal, monitored by the monitoring circuit 42, has a waveform which is less sharp than that of the input signal supplied from the signal application circuit 41 to the terminal TB1, it is highly likely for the test wiring section 19 to have an increased resistance due to the reason such as a breakdown.

The signal supplied to each of the terminals TA1 and TB1 from the signal application circuit 41 can be, but not limited to, a pulse signal, for example. For a simplified test, the signal supplied to each of the terminals TA1 and TB1 can be a DC level signal.

In this case, increases in resistances of the respective test wiring section 18 and at least one of the plurality of test wiring sections 14 cause voltage drops in proportion to currents flowing through the respective test wiring section 18 and at least one of the plurality of test wiring sections 14. It follows that DC level of the terminals TA2 is reduced more than that of the terminal TA1. It is thus possible to detect whether or not the test wiring section 18 and the plurality of test wiring sections 14 have their respective defects by detecting the reduction in DC level of the terminals TA2. The same applies to the terminals TB1 and TB2 and the test wiring section 19.

Note that, in a case where the test wiring sections 18 and the plurality of test wiring sections 14 have their respective normal resistances, the reduction in DC level of the terminal TA2 is so small that it is ignorable.

As described above, the test wiring section 18 and the plurality of test wiring sections 14 have respective higher resistances in the following malfunction cases than in normal case: (i) the test wiring section 18 and the plurality of test wiring sections 14 are almost in respective disconnected conditions and (ii) the test wiring section 18 and the plurality of test wiring sections 14 are in respective disconnected conditions. It follows that the output signal outputted from the terminal TA2, monitored by the monitoring circuit 42, becomes different from the input signal supplied to the terminal TA1 from the signal application circuit 41. That is, a voltage drop, across the respective parts whose resistances are increased, increase while the current is flowing through the respective parts. It becomes thus possible to detect defects of the respective test wiring section 18 and the plurality of test wiring sections 14. The same applies to the terminals TB1 and TB2 and the test wiring section 19.

It is possible to arrange a system so that information indicating that there is a defect in the connection condition between the display panel 11 and the plurality of COFs 12 is fed back to the host system 44 via the test circuit 43 included in the liquid crystal display device 40, in a case where it is determined, by use of the monitoring method described above, that there is a defect in the connection condition between the display panel 11 and the plurality of COFs 12. The host system 44 is a signal source connected to the liquid crystal display device 40. The host system 44 can carry out a preventative control, such as turning off a backlight of the liquid crystal display device 40 or stopping a voltage supply to the liquid crystal display device 40, in response to the information on the connection condition between the display panel 11 and the plurality of COFs 12.

Further, the connection condition between the display panel 11 and the plurality of COFs 12 can be monitored by (i) causing a signal source, which is provided on one of the plurality of COFs 12, serving as a substrate on which a driving circuit is provided, to supply the input signals to the respective terminals TA1 and TB1 and (ii) monitoring output signals outputted from the respective terminals TA2 and TB2. Alternatively, it is possible to arrange wiring lines so that the host system 44, serving as the signal source for the liquid crystal display device 40, controls all of the terminals TA1, TA2, TB1, and TB2.

In a case where the control can be carried out in the liquid crystal display device 40 without the host system 44, the liquid crystal display device 40 itself can carry out the control, such as turning on or off the backlight of the liquid crystal display device 40, in response to the information on the connection condition between the display panel 11 and the plurality of COFs 12.

Instead, it is possible to (i) compare (a) a measured resistance of the wiring line defined by the plurality of test wiring sections 14, the test wiring section 18, and the plurality of short-circuit wiring lines 21 and (b) a reference resistance of the wiring line which has been measured in advance with each other and (ii) compare (c) a measured resistance of the wiring line defined by the test wiring section 9 and the plurality of short-circuit wiring lines 15 and (d) a reference resistance of the wiring line which has been measured in advance with each other. Such comparisons make it possible to estimate (i) the broken condition of the plurality of COFs 12 and the like or (ii) the connection condition between the display panel 11 and the plurality of COFs 12 and the connection condition between the plurality of COFs 12 and the PWB 16. In a case where each resistance of the wiring lines is much higher than a corresponding normal resistance, i.e., the resistance measured in the normal connection condition, it is believed that such a wiring line is almost in a disconnected condition. The terminals TA1, TA2, TB1, and TB2 can be used in the measurement of each resistance of the wiring lines.

Further, it is possible to detect, for each of the plurality of COFs, a possibility of a breakdown of one of lateral end parts of such a COF 12 or a possibility of a poor connection condition of each of the connection parts of such a COF 12, by measuring (i) a resistance between the terminals TX1 and TX2, and (ii) a resistance between the terminals TY1 and TY2.

According to the present embodiment, (i) the plurality of short-circuit wiring lines 21 are provided on the display panel 11 (ii) the plurality of test wiring sections 14 and the plurality of short-circuit wiring lines 15 are provided on the respective plurality of COFs 12, and (iii) the test wiring section 18 and the plurality of short-circuit wiring lines 21 are connected to each other and the test wiring section 19 and the plurality of short-circuit wiring lines 15 are connected to each other. Further, the terminals TA1 and TA2 are electrically connected to the test wiring section 18, while the terminals TB1 and TB2 are electrically connected to the test wiring section 19. The conditions of the output signals outputted from the respective terminals TA2 and TB2 with respect to the respective conditions of the input signals supplied to the respective terminals TA1 and TB1 are thus confirmed. As such, it is possible to easily estimate (i) the broken condition of the plurality of COFs 12 and (ii) the connection condition between the display panel 11 and the plurality of COFs 12 and the connection condition between the plurality of COFs 12 and the PWB 16, while the display device including the display panel 1 is in use. Alternatively, it is possible to estimate the broken condition or the connection conditions by comparing (i) the measured resistances between the terminals TA1 and TA2 with the normal resistances measured in advance and (ii) the measured resistance between the terminals TB1 and TB2 with the normal resistance measured in advance.

The following description deals with a modification of the present embodiment. Fig. 5 is a plan view illustrating the modified example.

According to the present modification, a further liquid crystal display device 50 includes a display panel 23, a plurality of COFs 24, and a PWB 25.

Each of the plurality of COFs 24 has the same arrangement as that of the COF 12 except that such a COF 24 further includes a test wiring section 26. The test wiring section 26 is provided closer to one of lateral end parts of the COF 24 than a corresponding one of the foregoing plurality of short-circuit wiring lines 15 of the plurality of COFs 12. The test wiring section 26 is defined by wiring lines 26a and 26b which are juxtaposed to each other.

The display panel 23 has the same arrangement as that of the display panel 11 except that the display panel 23 further includes a plurality of short-circuit wiring lines 27. Each of the plurality of short-circuit wiring lines 27 is provided so as to short-circuit a corresponding one of the plurality of wiring lines 26a and a corresponding one of the plurality of wiring lines 26b, like the plurality of short-circuit wiring lines 21.

The PWB 25 has the same arrangement as the PWB 16 except that the PWB 25 further includes test wiring section 28. The test wiring section 28 is defined by a plurality of wiring lines 28a, a plurality of wiring lines 28b, and a wiring line 28d. The test wiring section 28 is connected to the plurality of test wiring sections 26, just as the test wiring section 18 is connected to the plurality of test wiring sections 14. Further, terminals TZ1 and TZ2, which have the same functions as the respective terminals TX1 and TX2, are provided for each of the plurality of COFs 24.

Furthermore, a terminal TC1 is connected to a signal application circuit 51, like the terminals TA1 and TB2, and a terminal TC2 is connected to a monitoring circuit 52, like the terminals TA2 and TB2. The signal application circuit 51 and the monitoring circuit 52 are included in a test circuit 53 which is connected to a host system 54.

According to the arrangement, the plurality of test wiring sections 26, the test wiring section 28, and the plurality of short-circuit wiring lines 27 are electrically connected to each other so as to serve as a single wiring line. Such a wiring line makes it possible to carry out an electric test or a resistance measurement test which is carried out, with the use of a signal, by electrically connecting the plurality of test wiring sections 14, the test wiring section 18, and the plurality of short-circuit wiring lines 21. It becomes thus possible to estimate (i) a broken condition of the lateral end parts of a COF 24, which lateral end parts are likely to be subjected to stresses and/or (ii) a connection condition between the display panel 23 and the respective plurality of COFs 24 and/or a connection condition between the respective plurality of COFs 24 and the PWB 25, while the display device having the arrangement employing the present modification is in use.

Note that the present embodiment describes the case where each test wiring section 14 and a corresponding one of the plurality of short-circuit wiring lines 15 are provided in the vicinity of the respective lateral end parts of a corresponding one of the plurality of COFs 12 (24). However, the present embodiment is not limited to this. Either the plurality of test wiring sections 14 or the plurality of short-circuit wiring lines 15 can be omitted in a case where there is a restriction in layout of pins of the COF 12 (24).

Note that dummy wiring lines 41 and 42 can be further provided on each of the plurality of COFs 12 (24) (see dashed-dotted lines shown in Figs. 3 and 5) of the present embodiment. Each dummy wiring line 41 is provided between a corresponding one of the plurality of test wiring sections 14 and one of edges of a corresponding one of the plurality of COFs 12 (24), and each dummy wiring line 42 is provided between a corresponding one of the plurality of short-circuit wiring lines 15 and the other one of the edges of the corresponding one of the plurality of COFs 12 (24).

Generally, the dummy wiring lines 41 and 42 are provided so as to be independent from, i.e., so as not to be electrically connected to the display panel 11 (23) and an external device. Such dummy wiring lines 41 and 42 serve as members for reinforcing each of the plurality of COFs 12 (24). Therefore, it is possible for lateral end parts of each of the plurality of COFs 12 (24) to have higher strengths.

Note that the dummy wiring lines 41 and 42 can be electrically connected to either the display panel 11 (23) or the PWB 16 (25), if necessary.

### [Embodiment 3]

Fig. 6 illustrates an arrangement of still a further liquid crystal display device 101 of the present embodiment.

The liquid crystal display device 101 includes a liquid crystal display panel 102, a plurality of source drivers 103, a plurality of gate drivers 104, and a controller 105 (see Fig. 6). The liquid crystal display panel 102 is connected to a test circuit 113, like the display panels 1, 11, and 23. The test circuit 113 includes a signal application circuit 111 and a monitoring circuit 112. The test circuit 113 is connected to a host system 114 to which the liquid crystal display device 101 is connected.

The liquid crystal display panel 102 includes a plurality gate bus lines, i.e., (m × i) gate bus lines G11 through Gmi, a plurality source bus lines, i.e., (n×j) source bus lines S11 through Snj, and a plurality of pixels PIX.

Hereinafter, the plurality of gate bus lines G11 trough Gmi are collectively referred to as "gate bus line G" in some cases, if necessary. Further, hereinafter, the plurality of source bus lines S11 through Snj are collectively referred to as "source bus line S" in some cases, if necessary.

The plurality of pixels PIX are provided near from intersections of the gate bus line G and the source bus line S. each of the plurality of pixels PIX includes a display element DE and a thin-film transistor (hereinafter, merely referred to as "transistor") which is provided on a glass substrate of the liquid crystal panel 102.

In the transistor, (i) its gate is connected to the gate bus line G, (ii) its source is connected to the source bus line S, and (iii) its drain is connected to a pixel electrode (not illustrated). A common electrode (not illustrated), to which a common voltage is applied, is provided so as to face the pixel electrode. The display element DE is defined by the pixel electrode, the common electrode, and liquid crystal which is provided between the pixel electrode and the common electrode.

The plurality of gate bus lines G11 through Gmi, the plurality of source bus lines S11 through Snj, the plurality of transistors, and the plurality of pixel electrodes are provided on the glass substrate. The common electrode is provided on another glass substrate which is provided to face the above glass substrate. The liquid crystal is filled in a gap between the glass substrates (between the pixel electrode and the common electrode).

The number of the plurality of source drivers 103 is n. Each of the plurality of source drivers 103 includes a shift register which shifts a start pulse SSP at timing of a source clock signal SCK. Display data Dx is held on corresponding j source bus lines S at timing of a timing pulse outputted from each stage of outputs of the shift register. Each of the plurality of source drivers 103 causes latch circuits to latch the display data Dx thus held at timing of a latch signal LS so as to output the display data Dx to the corresponding j source bus lines S.

The number of the plurality of gate drivers 104 is m. Each of the plurality of gate drivers 104 includes a shift register which shifts a start pulse GSP at timing of a gate clock signal GCK. The gate driver 104 generates a gate pulse by a timing pulse outputted from each stage of outputs of the shift register so as to output gate pulses to corresponding i gate bus lines G.

The controller 105 generates control signals such as the start pulse SSP, the source clock signal SCK, and the latch signal LS each of which is supplied to the source drivers 103, and outputs the display data Dx to the source drivers 103. The controller 105 also generates control signals such as the start pulse GSP and the gate clock signal GCK each of which is supplied to the gate drivers 104.

The display panel 1, 11, or 23 is employed as the liquid crystal display panel 102 of the liquid crystal display device 101. The driver chip 3 of the display panel 1, (i) the COF 12 of the display panel 11 or (ii) the COF 24 of the display panel 23 is employed as each source driver 103 and each gate driver 104. Accordingly, in a case where the display panel 1 is employed as the liquid crystal display panel 102, the liquid crystal display panel 102 is connected to the FPC 2. In a case where the display panel 11 is employed as the liquid crystal display panel 102, the liquid crystal display panel 102 is connected to the PWB 2. Furthermore, in a case where the display panel 23 is employed as the liquid crystal display panel 102, the liquid crystal display panel 102 is connected to the PWB 25.

The liquid crystal display device 101 thus includes the display panel 1, 11, or 23, and it is therefore possible to easily estimate (i) a broken condition of lateral end parts of the FPC 2, or PWB 16 (25), which lateral end parts are likely to be subjected to stresses and/or (ii) a connection condition between the liquid crystal display panel 102 and the FPC 2 or a connection condition between the liquid crystal display panel 102 and the PWB 16 (25), while the liquid crystal display device 101 is in use.

The present embodiment has described the arrangement in which the liquid crystal display device 101 includes the display panel of Embodiment 1 or the display panel 11 (23) of Embodiment 2. Note, however, that the present embodiment is not limited to this, and the display panel 1, 11 or 23 can be employed in another display device such as an organic EL display or a plasma display, provided that the display panel 1, 11 or 23 can be driven by use of a driver chip in the another display device.

The present invention is not limited to the description of the embodiments above, but can be altered by a skilled person in the art within the scope of the claims. An embodiment derived from a proper combination of technical means disclosed in different embodiments is encompassed in the technical scope of the present invention.

The embodiments and concrete examples discussed in the detailed description serve solely to illustrate the technical details of the present invention, which should not be narrowly interpreted within the limits of such embodiments and concrete examples, but rather can be applied in many ways within the spirit of the present invention, provided that such modifications do not exceed the scope of the patent claims set forth below.

### Industrial Applicability

A liquid crystal display device and a method for testing a liquid crystal display device, in accordance with the present invention, are suitably applicable even to a display device such as an in-car display device. This is because it is possible to estimate a broken condition of a flexible substrate on which a signal wiring line is provided, while the display device is even in use, by checking a conductive condition of the signal wiring line connected to a driving circuit.

### Reference Signs List

1, 11, 23: Display panel
2: FPC (wiring board)
3, 13: Driver chip
4, 7, 17: Wiring pattern
5, 6, 21: Short-circuit wiring line (first short-circuit wiring line)
8, 9: Test wiring section
8a, 9a: Wiring line (first wiring line)
8b, 9b: Wiring line (second wiring line)
12, 24: COF
16, 25: PWB (wiring board)
14: Test wiring section
14a: Wiring line (third wiring line)
14b: Wiring line (fourth wiring line)
18, 28: Test wiring section
18a, 28a: Wiring line (first wiring line)
18b, 28b: Wiring line (second wiring line)
19: Test wiring section
19a: Wiring line
19b: Wiring line
30, 40, 50, 101: Liquid crystal display device
31, 41, 51, 111: Signal application circuit (signal application means)
32, 42, 52, 112: Monitoring circuit (comparison means)
33, 43, 53, 113: Test circuit
34, 44, 54, 114: Host system (control means)
102: Liquid crystal display panel (display panel)
T1, T3: Terminal (first terminal)
T2, T4: Terminal (second terminal)
TA1, TC1: Terminal (first terminal)
TA2, TC2: Terminal (second terminal)
TX1, TZ 1 : Terminal (first terminal)
TX2, TZ2: Terminal (second terminal)
TB 1: Terminal (third terminal)
TB2: Terminal (fourth terminal)
TY1: Terminal (third terminal)
TY2: Terminal (fourth terminal)

## Claims

1. A method for testing a liquid crystal display device,
the liquid crystal display device including:
a wiring board including (i) a signal supply line via which a signal for driving a display panel is supplied (ii) a first wiring line and a second wiring line which extend toward the display panel and (iii) a first terminal and a second terminal which are connected to the first wiring line and the second wiring line, respectively; and
a display panel including a first short-circuit wiring line via which the first wiring line and the second wiring line are to be short-circuited in a connection part between the wiring board and the display panel,
said method comprising the steps of:
(a) causing the wiring board and the display panel 1 to be connected to each other;
(b) applying a signal to the first terminal; and
(c) comparing the signal applied to the first terminal with a signal outputted from the second terminal.

2. The method as set forth in claim 1, wherein:
in the step (a), the wiring board and the display panel are connected to each other via an intermediate substrate, which includes (i) a wiring line via which a signal is communicated between the display panel and the wiring board and (ii) a third wiring line and a fourth wiring line, so that (1) the first wiring line and the first short-circuit wiring line are electrically connected via the third wiring line and (2) the second wiring line and the first short-circuit wiring line are electrically connected via the fourth wiring line.

3. The method as set forth in claim 2, wherein:
the wiring board further includes (i) a fifth wiring line and a sixth wiring line and (ii) a third terminal and a fourth terminal which are connected to the fifth wiring line and the sixth wiring line, respectively;
the intermediate substrate further includes a second short-circuit wiring line via which the fifth wiring line and the sixth wiring line are to be short-circuited in a connection part between the wiring board and the intermediate substrate; and
said method further comprising the steps of:
causing the wiring board and the intermediate substrate to be connected to each other;
applying a signal to the third terminal; and
comparing the signal applied to the third terminal with a signal outputted from the fourth terminal.

4. The method as set forth in claim 1, wherein:
the signal applied to the first terminal is a pulse signal.

5. The method as set forth in claim 1, wherein:
the signal applied to the first terminal is a DC signal.

6. A liquid crystal display device comprising:
a wiring board including (i) a signal supply line via which a signal for driving a display panel is supplied (ii) a first wiring line and a second wiring line which extend toward the display panel and (iii) a first terminal and a second terminal which are connected to the first wiring line and the second wiring line, respectively; and
a display panel including a first short-circuit wiring line via which the first wiring line and the second wiring line are to be short-circuited in a connection part between the wiring board and the display panel,
the wiring board and the display panel being connected to each other,
said liquid crystal display device further comprising:
signal application means for applying a signal to the first terminal; and
comparison means for comparing the signal applied to the first terminal with a signal outputted from the second terminal.

7. The liquid crystal display device as set forth in claim 6, wherein:
the first wiring line and the second wiring line are provided in at least one of lateral end parts of the wiring board.

8. The liquid crystal display device as set forth in claim 6, wherein:
the wiring board and the display panel are connected to each other via an intermediate substrate, which includes (i) a wiring line via which a signal is communicated between the display panel and the wiring board and (ii) a third wiring line and a fourth wiring line, so that (1) the first wiring line and the first short-circuit wiring line are electrically connected via the third wiring line and (2) the second wiring line and the first short-circuit wiring line are electrically connected via the fourth wiring line.

9. The liquid crystal display device as set forth in claim 8, wherein:
the wiring board further includes (i) a fifth wiring line and a sixth wiring line and (ii) a third terminal and a fourth terminal which are connected to the fifth wiring line and the sixth wiring line, respectively;
the intermediate substrate further includes a second short-circuit wiring line via which the fifth wiring line and the sixth wiring line are to be short-circuited in a connection part between the wiring board and the intermediate substrate;
the signal application means applies a signal to the third terminal; and
the comparison means compares the signal applied to the third terminal with a signal outputted from the fourth terminal.

10. The liquid crystal display device as set forth in claim 8, wherein:
the intermediate substrate is made up of a plurality of intermediate substrates; and
the wiring board and the display panel are connected to each other via the plurality of intermediate substrates.

11. The liquid crystal display device as set forth in claim 9, wherein:
each of the plurality of intermediate substrates includes the fifth wiring line and the sixth wiring line in each of its lateral end parts.

12. The liquid crystal display device as set forth in claim 8, wherein:
the wiring board is a printed wiring board; and
the intermediate substrate is a wiring board in which an integrated circuit for driving the display panel is provided on a film.
